# EUROPÄISCHE PATENTANMELDUNG

(11) **EP 2 133 983 A2**
(43) Veröffentlichungstag der Anmeldung: **16.12.2009**
(21) Anmeldenummer: 09160521.2
(22) Anmeldetag: 18.05.2009
(51) Int. Cl.: H02M 5/10, H02M 5/22

(54) **Vorrichtung zur Umformung elektrischer Energie zur konduktiven Erhitzung von Halbleitermaterial in Stabform**

(30) Priorität: 03.06.2008 DE 102008002184
(71) Anmelder: Wacker Chemie AG, 81737 München (DE)
(72) Erfinder: Ellinger, Norbert, 84389, Postmünster (DE); Auer, Josef, 5122, Hochburg (AT); Fuchs, Paul, 5231, Schalchen (AT); Monz, Elmar, 84533, Marktl (DE)
(74) Vertreter: Fränkel, Robert

(57) **Zusammenfassung**

Die vorliegende Erfindung betrifft eine Vorrichtung zur Umformung elektrischer Energie zur konduktiven Erhitzung von stabförmigen Halbleitermaterialien.

## Beschreibung

Die Erfindung betrifft eine Vorrichtung zur Umformung elektrischer Energie zur konduktiven Erhitzung von stabförmigen Halbleitermaterialien in einem Gasstrom, im Nachfolgenden Kompaktstromversorgung genannt.

Kompaktstromversorgungen sind sowohl in der Industrie als auch im Handwerk weit verbreitet. Dabei werden Trafo, Regeltechnik, Gleichrichter und sonstige Bauteile derart angeordnet, dass ein minimaler Platzbedarf besteht und Verbindungen möglichst kurz ausgeführt werden.

Kompaktstromversorgungen werden beispielsweise in der Vermittlungstechnik, für Rechnersysteme und Maschinen- oder Industriesteuerungen im Gleich- und Wechselspannungsbereich zur Stromversorgung eingesetzt. Kompaktstromversorgungen kommen sowohl im einstelligen Wattbereich als auch im Megawattbereich in Industrieanlagen zum Einsatz.

Besonders geeignet sind Kompaktstromversorgungen bei der Umformung von elektrischer Energie zur konduktiven Erhitzung von Polysilicium in Stabform.

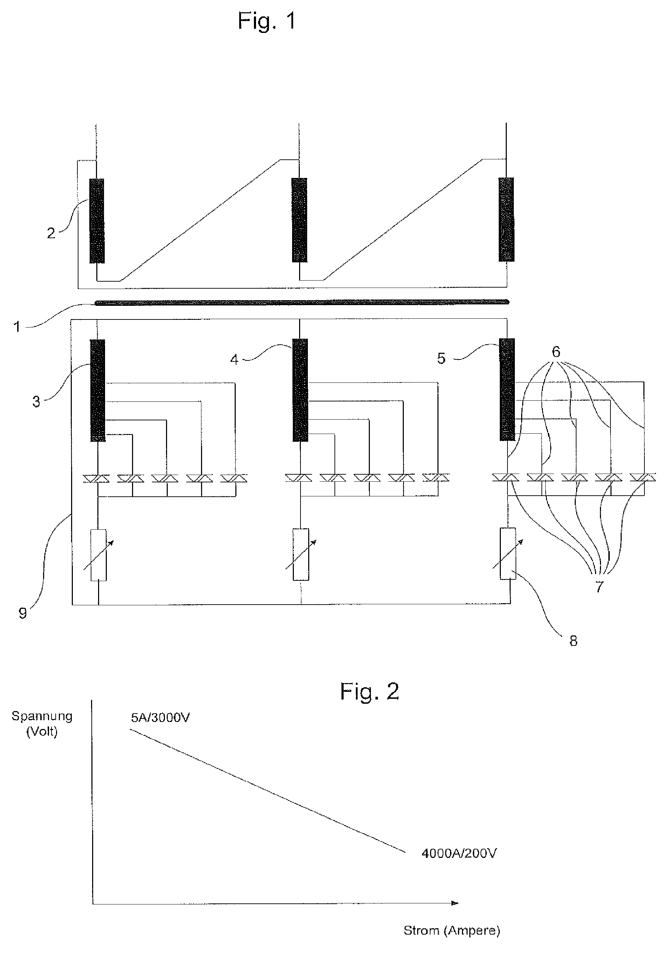

Der spezifische Widerstand von Halbleitermaterialien weist einen stark fallenden Temperaturkoeffizienten auf. Damit stellt sich die Problematik, dass die Stromversorgung eine hohe Ausgangsspannung (Volt) für kaltes Heizermaterial und eine hohe Stromstärke (Ampere) für heißes Heizermaterial liefern muss (Fig. 2).

Die Strom-/Spannungskennlinie kann exemplarisch als linear angenommen werden. Es handelt sich hierbei meist um Heizungsanwendungen mit hoher Heizenergie von einigen 100kW bis mehreren Megawatt. Wegen der hohen Leistung ist ein wirtschaftlicher Betrieb nur bei hohen Wirkungsgraden von größer 97 % möglich. Problematisch bei diesen hohen Leistungen ist der Effekt der so genannten Netzrückwirkung, wenn der Betrieb eines elektrischen Verbrauchers Einfluss auf die Stabilität und Form des Spannungsversorgungsnetzes nimmt.

Um Netzrückwirkungen möglichst gering zu halten, ist bei so hohen Leistungen ein niedriger Stromoberschwingungsgehalt und niedrige Verschiebungsblindleistung anzustreben. Darüber hinaus muss die Heizenergie symmetrisch 3-phasig aus dem speisenden Netz entnommen werden, um einphasige Netzverzerrungen zu verhindern. Die primäre Netzversorgungsspannung ist dabei weitgehend unerheblich und liegt üblicherweise zwischen 3 kV und 400 kV.

Eine weitere Besonderheit bei der Erhitzung von Halbleitermaterialien in einem kühlenden Gasstrom ist die schnelle und starke Widerstandsänderung mit der Temperatur. Diese Eigenschaft verlangt nach schnellen Leistungsregelungen der Heizenergie ohne, oder mit nur sehr kurzen energielosen Pausen.

Ein mechanisch optimierter Aufbau einer Kompaktstromversorgung ist des Weiteren für eine wirtschaftliche Anordnung der Hochstromkomponenten von erheblicher Bedeutung.

In der Industrie wurden die oben genannten Aufgaben mit Energieumformungsvorrichtungen bestehend aus einem Transformator mit unabhängigen Leistungsstellern je Spannungsanzapfung des Transformators gelöst.

Aus dem Gebrauchsmuster DE 202005010333 U1 ist eine einphasige Schaltungsanordnung beschrieben, welche zusätzlich einen Hilfsschalter "S" benötigt, der es ermöglicht, steuerbare Schaltmittel (z. B. Thyristoren) mit zum Teil reduzierter Spannungsfestigkeit zu verwenden (siehe Schaltmittel 20, 21 in dieser Schrift). In dieser Veröffentlichung wird eine Schaltungsanordnung (4) und ein Transformator (T) beschrieben, welche miteinander verbunden sind. Auf die räumliche Anordnung der Gesamtanlage wird aber nicht eingegangen. Die Kombination der elektrischen und mechanischen Eigenschaften ist ebenfalls nicht erwähnt.
Nachteilig an dieser Anordnung ist, dass eine zusätzliche Schaltanordnung "S" benötigt wird, auf die bei Verwendung von Schaltelementen (Halbleiterbauelemente aller Art) mit ausreichender Spannungsfestigkeit verzichtet werden könnte. Dies würde die Schaltung und damit die Konstruktion erheblich vereinfachen.

Aus dem Gebrauchsmuster DE 202004004655 U1 ist ebenfalls eine einphasige Schaltungsanordnung zur Versorgung von stark veränderlichen Lasten beschrieben. Auch hier handelt es sich um eine einphasige Trafo-/Stellerkombination. Die Schaltungsvorrichtung bezieht sich auf die Möglichkeit, zwei stark veränderliche Lasten erst parallel und dann in Serienschaltung zu verschalten. Auf die konstruktive Ausführung sowie die elektrischen Eigenschaften wird auch hier nicht eingegangen. Nachteilig an dieser Schaltungsanordnung ist es, dass durch die Parallel-/Serienumschaltung sich im Umschaltaugenblick an der Last eine energielose Pause (>20 ms) ergibt, die nicht gewünscht ist.

Die im Stand der Technik beschriebenen Anordnungen sind alle einphasig. Der zusätzliche Schaltungsaufwand, diese in dreiphasiger Ausführung zu bauen, ist erheblich und nicht wirtschaftlich.
Es bestand daher die Aufgabe, eine mehrphasige Schaltungsanordnung bereitzustellen, die die im Stand der Technik aufgeführten Nachteile nicht besitzt.

Gegenstand der Erfindung ist eine Drehstromrichteranordnung zur Umformung von elektrischer Energie mit eingeprägter Netzspannung in eine prozessabhängige variable elektrische Energie zur konduktiven Erhitzung von stabförmigen Halbleitermaterialien bestehend aus
(A) einer dreiphasigen Primärwicklung, die an das Versorgungsnetz angeschlossen ist und
(B) drei Sekundärwicklungen, wobei jede der drei Sekundärwicklungen des Anlagentransformators mehr als zwei Spannungsanzapfungen mit einem nachgeschaltetem Leistungssteller besitzt, welche elektrisch auf der transformatorabgewandten Seite direkt, ohne weiteres Schaltglied verbunden sind und
(C) drei Heizstromkreisen bestehend aus den Sekundärwicklungen und den beheizten Halbleitermaterialen, die zur separaten Regelung der Heizenergien mittels der Lastwiderstände in Sternschaltung verschaltet sind, wobei die Leistungskomponenten der Steller zur Volumenoptimierung örtlich unmittelbar am Drehstromtransformator angeordnet sind.

Die dreiphasige Primärwicklung des Drehstromanlagen-Transformators wird an das Versorgungsnetz angeschlossen. Üblicherweise beträgt die Anschlussspannung 3 kV bis 400 kV, vorzugsweise 3 x 10 kV.

Jede der drei Sekundärwicklungen (3, 4, 5) des Transformators besitzt mehr als zwei Spannungsanzapfungen. Bevorzugt sind 3 bis 10 Anzapfungen, besonders bevorzugt 4 bis 6. Die Lage der Anzapfungen an den Sekundärwicklungen wird jeweils unter Berücksichtigung der gewünschten Strom-/Spannungskennlinie (Fig. 2) netzrückwirkungsoptimiert für die jeweilige Anwendung festgelegt.

Jede Spannungsanzapfung an den Sekundärwicklungen besitzt einen nachgeschalteten Leistungssteller (7). Die Anzahl der Leistungssteller je Phase entspricht der Anzahl der Spannungsanzapfungen.
Die Leistungssteller bestehen im Wesentlichen aus antiparallel angeordneten Standardleistungsthyristoren mit Ansteuerelektronik. Es sind aber auch andere schaltende Leistungshalbleiter, wie Thyristoren bzw. Transistoren aller Art, denkbar.

Die Spannungsanzapfungen werden bevorzugt direkt elektrisch auf der transformatorabgewandten Seite ohne weiteres Schaltglied mit den Leistungsstellern verbunden.

Die Zündwinkel der Leistungssteller können getrennt voneinander vorgegeben werden und übernehmen die kontinuierlich erforderliche Spannungsstellung für die Beheizung der Halbleiterstäbe (8).

Die Regelelektronik für die Ansteuerung der Leistungshalbleiter kann innerhalb oder auch zur besseren Zugänglichkeit außerhalb des Hochenergiebereiches angeordnet werden.

Durch diese Schaltungsanordnung (mehrfach überlagerte Stellerausgangsspannung durch die Transformatoranzapfungen) wird ein hoher Leistungsfaktor (Wirkleistung/Scheinleistung)zwischen 0,87 - 1 gewährleistet.

Die Heizenergie je stabförmigem Halbleiter kann mit der erfindungsgemäßen Anordnung nahezu lückenlos bereit gestellt werden. Die maximale Lücke ist dabei die Dauer einer Sinushalbwelle.

Die Sternpunktverbindung (9) sorgt dafür, dass der Strom durch die 3 Lastwiderstände getrennt voneinander geregelt werden kann.

In einer bevorzugten Ausführungsform können die drei Heizstromkreise bestehend aus den Sekundärwicklungen und den beheizten Halbleitermaterialen anstatt mit der beschriebenen Sternpunktverbindung auch potenzialgetrennt mit drei Einzelstromrückführungen (eine je Phase) ausgeführt werden.

Die Kommunikation der Regelelektronik mit dem Leistungsteil kann mittels optischer oder nicht optischer Datenverbindungen erfolgen.

Anhand der erfindungsgemäßen Schaltungsanordnung wird eine sehr raumsparende Vorrichtung zur Umformung elektrischer Energie zur konduktiven Erhitzung von Halbleitermaterial erzielt. Daraus ergibt sich bei der Herstellung und dem Betrieb derartiger Schaltungsanordnungen eine Kosten- und Raumersparnis gegenüber bekannten Anlagen, wie sie derzeit in der Industrie verwendet werden.
Mit der erfindungsgemäßen Anordnung konnten im beschriebenen Last- und Stellbereich erstmals Umformungsvorrichtungen mit einem Raumvolumen < 13 m³ gebaut werden.

Anhand des folgenden Beispiels soll die Erfindung näher erläutert werden.

### Beispiel 1:

Es wurde eine dreiphasige Schaltungsanordnung analog Figur 1 gebaut, deren drei Primärwicklungen (2) an das Versorgungsnetz angeschlossen wurden. Die drei Sekundärwicklungen (3, 4, 5) wurden jeweils mit 5 Spannungsanzapfungen (6) ausgeführt. Jede dieser Spannungsanzapfungen an den Sekundärwicklungen besitzt einen nachgeschalteten Leistungssteller (7). Die Leistungssteller bestehen aus antiparallel angeordneten Standardleistungsthyristoren mit Ansteuerelektronik.

Die Anlage hat einen regelbaren Ausgangsleistungbereich von 0 bis 5 MVA. Die Drehstromanordnung verursacht bei symmetrischer Last symmetrische Netzrückwirkungen.
Das umbaute Volumen der Drehstromrichteranlage beträgt ca. 13 m³. Der Nennwirkungsgrad beträgt > 97 %. Bei laufender Anlage besteht ein stetiger Energieeintrag in das Halbleitermaterial.
Der maximale Ausgangsstrombereich beträgt 3 x 0 - 4000 A, wobei jede Phase separat regelbar ist. Der maximale Ausgangsspannungsbereich (Ua) beträgt 3 x 50 - 3000 V.

## Patentansprüche

1. Drehstromrichter-anordnung zur Umformung von elektrischer Energie mit eingeprägter Netzspannung in eine prozessabhängige variable elektrische Energie zur konduktiven Erhitzung von stabförmigen Halbleitermaterialien bestehend aus
(A) einer dreiphasigen Primärwicklung, die an das Versorgungsnetz angeschlossen ist und
(B) drei Sekundärwicklungen, wobei jede der drei Sekundärwicklungen des Anlagentransformators mehr als zwei Spannungsanzapfungen mit einem nachgeschaltetem Leistungssteller besitzt, und
(C) drei Heizstromkreisen bestehend aus den Sekundärwicklungen und den beheizten Halbleitermaterialen, die zur separaten Regelung der Heizenergien mittels der Lastwiderstände in Sternschaltung verschaltet sind, wobei die Leistungskomponenten der Steller zur Volumenoptimierung örtlich unmittelbar am Drehstromtransformator angeordnet sind.

2. Verfahren nach Anspruch 1, **dadurch gekennzeichnet, dass** die Lage der Anzapfungen an den Sekundärwicklungen unter Berücksichtigung der gewünschten Strom-/Spannungskennlinie netzrückwirkungsoptimiert für die jeweilige Anwendung festgelegt wird.

3. Verfahren nach Anspruch 1 bis 2, **dadurch gekennzeichnet, dass** die Leistungssteller aus antiparallel angeordneten Standardleistungsthyristoren mit Ansteuerelektronik bestehen.

4. Verfahren nach Anspruch 1 bis 3, **dadurch gekennzeichnet, dass** die Spannungsanzapfungen direkt auf der transformatorabgewandten Seite, ohne weiteres Schaltglied mit den Leistungsstellern verbunden sind.

5. Verfahren nach Anspruch 1 und 4, **dadurch gekennzeichnet, dass** die Zündwinkel der Leistungssteller getrennt voneinander vorgegeben werden und diese die kontinuierlich erforderliche Spannungsstellung für die Beheizung der Halbleiterträgerstäbe übernehmen.

6. Verfahren nach Anspruch 1 bis 5, **dadurch gekennzeichnet, dass** die Regelelektronik für die Ansteuerung der Leistungshalbleiter innerhalb oder außerhalb des Hochenergiebereiches angeordnet ist.

7. Verfahren nach Anspruch 1 **dadurch gekennzeichnet, dass** die drei Heizstromkreise bestehend aus den Sekundärwicklungen und den beheizten Halbleitermaterialien nicht mit einer Sternpunktverbindung, sondern potenzialgetrennt mit jeweils einer separaten Einzelstromrückführung je Phase ausgeführt sind.

8. Verfahren nach Anspruch 1 bis 7, **dadurch gekennzeichnet, dass** die Heizenergie je stabförmigem Halbleiter lückenlos bereit gestellt werden kann.

9. Verfahren nach Anspruch 1 bis 8, **dadurch gekennzeichnet, dass** die Drehstromrichteranordnung ein umbautes Volumen von < 13 m³ besitzt.
